Europäisches Patentamt

European Patent Office

Office européen des brevets

(11) Veröffentlichungsnummer: **0 308 749**
**A2**

## EUROPÄISCHE PATENTANMELDUNG

(21) Anmeldenummer: **88114780.5**

(22) Anmeldetag: **09.09.88**

(51) Int. Cl.⁴: **H01L 31/02**

(30) Priorität: **25.09.87 DE 3732391**

(43) Veröffentlichungstag der Anmeldung:
**29.03.89 Patentblatt 89/13**

(84) Benannte Vertragsstaaten:
**DE FR GB IT**

(71) Anmelder: **Siemens Aktiengesellschaft Berlin und München**
**Wittelsbacherplatz 2**
**D-8000 München 2(DE)**

(72) Erfinder: **Taumberger, Franz**
**Stiftsbogen 118**
**D-8000 München 70(DE)**

(54) **Elektrooptische Baugruppe.**

(57) Bei der Montage von Empfängermodulen für die Lichtwellenleiterübertragung in ein Modulgehäuse besteht das Problem, daß ein hochpräziser Einbau vorgenommen werden muß, der wegen der Gefahr der Verschmutzung optischer Oberflächen nicht mittels Kleben oder Löten erfolgen darf. Erfindungsgemäß wird die eine integrierte Schaltung und Verstärkerelemente enthaltende Schichtschaltung mit dem Keramiksubstrat über einen blechförmigen Zwischenträger mit dem Gehäuseboden verbunden. Die Verbindung der Schichtschaltung mit dem Zwischenträger kann durch eine der üblichen Techniken wie Kleben, Löten oder Legieren geschehen, während die Befestigung am Gehäuseboden über von der Schichtschaltung nicht bedeckte Randstreifen des Zwischenträgers mittels Laser- oder Widerstandsschweißen erfolgt.

## FIG 1

EP 0 308 749 A2

# Elektrooptische Baugruppe

Die Erfindung betrifft eine elektrooptische Baugruppe entsprechend dem Oberbegriff des Anspruches 1.

Die Entwicklung der Elektrooptik, insbesondere die Entwicklung der Signalübertragung über Lichtwellenleiter führt zu Baugruppen, in denen optische Bauelemente und elektrische Bauelemente, wie beispielsweise Schichtschaltungen vereinigt sind. Bei der Herstellung derartiger Baugruppen besteht das Problem daß die optischen Bauelemente wegen der geringen Lichtamplituden auch vor der geringsten Verschmutzung zu schützen sind. Übliche Verfahren zur Befestigung von Schichtschaltungen in einem Gehäuse sind die Lötung mittels Flußmittel oder das Kleben mit einem in der Regel Lösungsmittel enthaltenden Kleber, so daß diese Verfahren in Verbindung mit optischen Bauelementen nicht anwendbar sind.

Aus der EP-A2-0118677 ist z.B. ein Verfahren zum Einstellen eines lichtempfangenden Endes eines Lichtleiters im Brennpunkt einer Linse und eine dafür geeignete Vorrichtung beschrieben. Dabei wird das Lichtleiterelement mit Hilfe von Klebstoff mit einem Linsenträgerelement fest verbunden. Sofern dabei optisch wirksame Oberflächen freiliegen, besteht die Gefahr einer Verschmutzung durch Komponenten eines Epoxydharzklebers oder durch Lösungsmittel für den Klebstoff.

Zusätzlich besteht bei der Herstellung der elektrooptischen Baugruppen das Problem, daß - wegen der geringen Abmessungen der Lichtwellenleiter und damit des zu übertragenden Lichtstrahls -eine sehr genaue Montage der optischen und optoelektrischen Bauelemente erfolgen muß. Insbesondere bei der Montage von Schichtschaltungen, die optoelektronische Bauelemente enthalten, ergibt sich dabei das Problem, daß weder die üblichen Montagemethoden aus der Optik als auch die Befestigungsmethoden aus der Schichtschaltungstechnik Verwendung finden können.

Die Aufgabe der Erfindung ist es also, eine hochpräzise lagerichtige Montage einer ein optoelektrisches Bauelement enthaltenden Schichtschaltung in einem, optische Bauelemente enthaltenden Metallgehäuse bei Verzicht auf Kleben und Löten zu ermöglichen.

Erfindungsgemäß wird die Aufgabe durch eine elektrooptische Baugruppe gelöst, die entsprechend den Kennzeichen des Patentanspruches 1 ausgebildet ist. Zweckmäßige Weiterbildungen der erfindungsgemäßen elektrooptischen Baugruppe sind in den Patentansprüchen 2 bis 5 und ein Herstellungsverfahren ist im Patentanspruch 6 beschrieben. Die erfindungsgemäße elektrooptische Baugruppe kommt dabei in vorteilhafter Weise ohne eine nachfolgende Reinigung aus, weiterhin kann in vorteilhafter Weise vor dem Einsetzen des optoelektrischen Bauelementes in die Schichtschaltung diese mittels eines der üblichen Herstellungsverfahren erzeugt werden, so daß der beschriebene Aufbau für eine Vielzahl unterschiedlicher Schichtschaltungen geeignet ist, durch den metallischen Zwischenträger ergibt sich außerdem ein guter thermischer Kontakt zwischen Schichtschaltung und Gehäuseboden.

Die Erfindung soll im Folgenden anhand eines in der Zeichnung dargestellten Ausführungsbeispiels näher erläutert werden.

Dabei zeigt:

Fig. 1 einen Schnitt durch eine erfindungsgemäße elektrooptische Baugruppe und

Fig. 2 die Draufsicht auf die Baugruppe nach Fig. 1 bei entfernter Abschirmkappe.

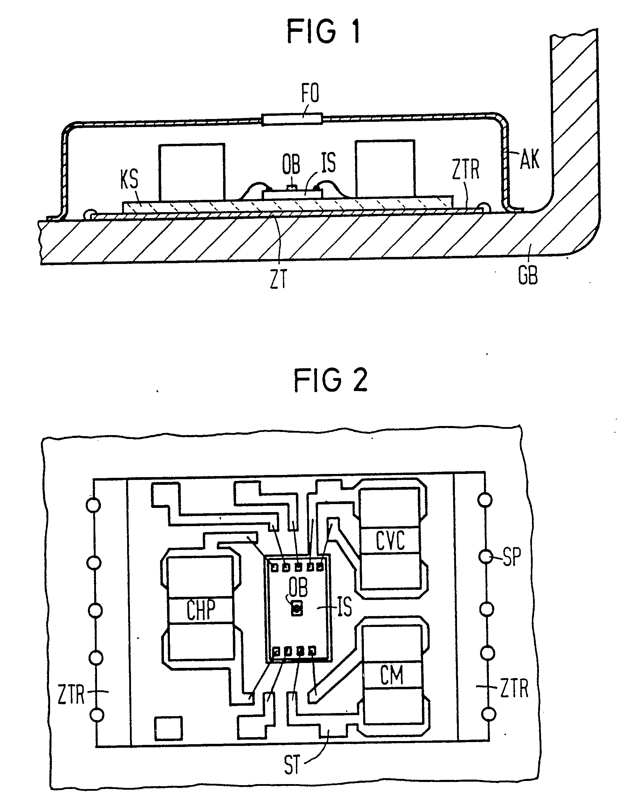

In der Fig. 1 ist mit GB der metallische Gehäuseboden bezeichnet, der Teil eines Metallgehäuses ist, in dem ein Empfängermodul für die optische Signalübertragung über Lichtwellenleiter sowie ein Spiegel und ein optischer Filter eingebaut sind. Die integrierte Schaltung IS mit dem optoelektrischen Bauelement OB ist als Teil der Schichtschaltung SS auf dem Keramiksubstrat KS befestigt, das großflächig auf einen Zwischenträger aus vergleichsweise dünnem Blech befestigt ist, der seinerseits auf den Gehäuseboden GB montiert ist. Die Befestigung des Substrats auf dem Zwischenträger ZT erfolgt durch Löten-, Kleben und Legieren sind ebenfalls möglich. Der Zwischenträger ZT weist eine größere Fläche als das Keramiksubstrat KS auf, so daß an 2 gegenüberliegenden Seiten Randstreifen über das Keramiksubstrat KS hinausragen, die zur Befestigung am Gehäuseboden dienen.

Die integrierte Schaltung IS enthält neben dem optoelektrischen Bauelement auch eine elektrische Verstärkeranordnung. Aus diesem Grunde ist die gesamte Schichtschaltung durch eine metallische Abschirmkappe AK vor elektrischen Einstreuungen geschützt, über dem optoelektrischen Bauelement der Schichtschaltung SS ist in der Abschirmkappe AK ein optisches Fenster FO in Form einer lichtdurchlässigen Glasscheibe eingesetzt. Der Zwischenträger ZT ist aus Vacon 10 gefertigt, dieses Material weist einen thermischen Ausdehnungskoeffizienten auf, der zwischen dem des Keramiksubstrates KS und dem des Gehäusebodens GB liegt. Die Verbindung des Zwischenträgers ZT und der Abschirmkappe AK mit dem Gehäuseboden geschieht über Schweißpunkte, die mittels Laserschweißverfahren erzeugt wurden. Der Wärmefluß von der Schichtschaltung über das Keramiksubstrat und den Zwischenträger zum Gehäuseboden hat sich als gut erwiesen.

In der in Fig. 2 gezeigten Draufsicht auf die elektrooptische Baugruppe nach der Erfindung ist erkennbar, daß auf dem Substrat als Teil der Schichtschaltung drei Kondensatorchips CHP, CVC, CM angeordnet sind, die über Kontaktstreifen und Bonddrähte mit der integrierten Schaltung IS in elektrischer Verbindung stehen. Der Zwischenträger ragt dabei unter der Schichtschaltung hervor und bildet auf 2 gegenüberliegenden Seiten Randstreifen ZTR, die an der Kante über Schweißpunkte SP mit dem Gehäuseboden verbunden sind.

Im Folgenden soll das Herstellungsverfahren für die elektrooptische Baugruppe nach Figuren 1 und 2 erläutert werden. In einem ersten Verfahrensschritt werden auf dem Keramiksubstrat KS die Kontaktflecken für die Kondensatoren CHP, CVC und CM sowie eine metallisierte Trägerfläche für die integrierte Schaltung IS erzeugt. Danach erfolgt die Bestückung der Schichtschaltung mit den einzelnen Bauelementen, die Befestigung dieser Bauelemente, beispielsweise durch Thermobonden sowie die Befestigung der Schichtschaltung auf dem Zwischenträger ZT. Danach wird die Schichtschaltung mit dem Zwischenträger lagerichtig auf dem Gehäuseboden mit einem maximalen Fehler von etwa ± 25 μm justiert und mittels Laserschweißen die Randstreifen des Zwischenträgers mit dem Gehäuseboden verschweißt. Der Zwischenträger wird dadurch mit dem Keramiksubstrat KS auf den Gehäuseboden gepreßt, um den Wärmefluß vom Keramiksubstrat zum Gehäuseboden sicherzustellen. Anstelle Laserschweißen kann auch ein Widerstandsschweißverfahren zur Erzeugung der Schweißpunkte SP oder einer Schweißnaht Verwendung finden. Abschließend wird die Abschirmkappe AK mit dem optischen Fenster FO über der Schichtschaltung SS so justiert, daß das optische Fenster über dem optoelektrischen Bauelement OB der integrierten Schaltung IS liegt und die Abschirmkappe AK ebenfalls mittels Laserschweißen oder Widerstandsschweißen mit dem Gehäuseboden verbunden. Im Hinblick auf das verwendete Schweißverfahren ist der Zwischenträger ganzflächig vernickelt und partiell vergoldet, auch die Abschirmkappe ist vernickelt.

## Ansprüche

1. Elektrooptische Baugruppe, die in einem abgedichteten Gehäuse mit metallischem Gehäuseboden optische Bauelemente und eine auf einem Substrat angeordnete Schichtschaltung mit wenigstens einem optoelektrischen Bauelement enthält, **dadurch gekennzeichnet,** daß das Substrat (KS) mit der der Schichtschaltung (SS) abgewandten Oberflächenseite großflächig auf einem Zwischenträger (ZT) befestigt ist, der aus einem vergleichsweise dünnen Blech besteht und eine größere Fläche als das Substrat aufweist, daß an wenigstens 2 gegenüberliegenden Seiten Randstreifen (ZTR) des Zwischenträgers (ZT) über das Substrat (KS) hinausragen und daß die Randstreifen (ZTR) über Schweißpunkte (SP) mit dem Gehäuseboden (GB) verbunden sind.

2. Elektrooptische Baugruppe nach Patentanspruch 1, **dadurch gekennzeichnet,** daß eine metallische Abschirmkappe (AK) vorgesehen ist, die das Substrat (KS) mit der Schichtschaltung (SS) überdeckt und oberhalb des in der Schichtschaltung enthaltenen optoelektrischen Bauelements ein optisches Fenster (FO) aufweist und daß die Abschirmkappe (AK) durch Schweißpunkte (SP) mit dem Gehäuseboden (GB) verbunden ist.

3. Elektrooptische Baugruppe nach Patentanspruch 1, **dadurch gekennzeichnet,** daß der Zwischenträger (ZT) einen thermischen Ausdehnungskoeffizienten aufweist, der etwa dem des Substrats (KS) entspricht.

4. Elektrooptische Baugruppe nach Patentanspruch 1, **dadurch gekennzeichnet,** daß der Zwischenträger (ZT) einen thermischen Ausdehnungskoeffizienten aufweist, der zwischen dem thermischen Ausdehnungskoeffizienten des Substrats (KS) und dem des Gehäusebodens (GB) liegt.

5. Elektrooptische Baugruppe nach Patentansprüchen 1 oder 2, **dadurch gekennzeichnet,** daß die Schweißpunkte (SP) zu einer Schweißnaht verbunden sind.

6. Verfahren zur Herstellung einer elektrooptischen Baugruppe nach einem der Patentansprüche 1 - 5, **dadurch gekennzeichnet,** daß in anfänglichen Verfahrensschritten getrennt das Gehäuse und die Schichtschaltung hergestellt werden,
daß anschließend die Schichtschaltung (SS) auf dem Zwischenträger (ZT) befestigt wird, daß in einem folgenden Verfahrensschritt die auf dem Zwischenträger (ZT) montierte Schichtschaltung (SS) in das Gehäuse eingebracht und auf dem Gehäuseboden (GB) justiert wird, daß danach die Randstreifen (ZTR) des Zwischenträgers (ZT) mit dem Gehäuseboden verschweißt werden,
daß anschließend die Abschirmkappe (AK) mit dem optischen Fenster (FO) über der Schichtschaltung justiert und mit dem Gehäuseboden verschweißt wird
und daß abschließend das Gehäuse durch den Einbau weiterer Bauelemente und Gehäuseteile komplettiert und dicht verschlossen wird.

# FIG 1

# FIG 2